(19) Europäisches Patentamt

European Patent Office

Office européen des brevets

(11) EP 0 905 796 B1

(12) EUROPÄISCHE PATENTSCHRIFT

(45) Veröffentlichungstag und Bekanntmachung des Hinweises auf die Patenterteilung:
03.04.2002 Patentblatt 2002/14

(51) Int Cl.$^7$: H01L 31/18, C01B 33/037, H01L 21/306

(21) Anmeldenummer: 98116156.5

(22) Anmeldetag: 27.08.1998

(54) **Verfahren zur herstellung von Silicium**

Manufacturing process of silicon

Procédé de fabrication de silicium

(84) Benannte Vertragsstaaten:
DE IT

(30) Priorität: 19.09.1997 DE 19741465

(43) Veröffentlichungstag der Anmeldung:
31.03.1999 Patentblatt 1999/13

(73) Patentinhaber: Wacker-Chemie GmbH
81737 München (DE)

(72) Erfinder:
• Wochner, Hanns, Dr.
84489 Burghausen (DE)
• Bauer, Theresia, Dr.
84508 Burgkirchen (DE)
• Dietl, Josef, Dr.
84524 Neuötting (DE)
• Ott, Werner
84367 Tann (DE)
• Schmidbauer, Wilhelm
84547 Emmerting (DE)
• Seifert, Dieter, Dr.
84524 Neuötting (DE)
• Weizbauer, Susanne, Dr.
83024 Rosenheim (DE)
• Pichler, Herbert
5122 Hochburg/Ach (AT)

(74) Vertreter: Rimböck, Karl-Heinz, Dr. et al
c/o Wacker-Chemie GmbH
Zentralabteilung PML
Hanns-Seidel-Platz 4
81737 München (DE)

(56) Entgegenhaltungen:
EP-A- 0 548 504          DE-A- 4 209 865
DE-A- 19 529 518

• PATENT ABSTRACTS OF JAPAN vol. 018, no. 590 (E-1628), 10. November 1994 & JP 06 224169 A (SHARP CORP), 12. August 1994
• KERN W ET AL: "CLEANING SOLUTIONS BASED ON HYDROGEN PEROXIDE FOR USE IN SILICON SEMICONDUCTOR TECHNOLOGY" RCA REVIEW, Bd. 31, Juni 1970, Seiten 187-206, XP000605014
• PATENT ABSTRACTS OF JAPAN vol. 017, no. 259 (C-1061), 21. Mai 1993 & JP 05 004811 A (SHIN ETSU HANDOTAI CO LTD), 14. Januar 1993
• PATENT ABSTRACTS OF JAPAN vol. 018, no. 225 (E-1541), 22. April 1994 & JP 06 021034 A (NEC KYUSHU LTD), 28. Januar 1994

**Beschreibung**

Die Erfindung betrifft ein Verfahren zur Herstellung von Silicium, insbesondere von polykristallinem Silicium.

Für die Herstellung von Solarzellen oder elektronischen Bauelementen, wie beispielsweise Speicherelementen oder Mikroprozessoren, wird hochreines Halbleitermaterial benötigt. Die gezielt eingebrachten Dotierstoffe sind die einzigen Verunreinigungen, die ein derartiges Material im günstigsten Fall aufweisen sollte. Man ist daher bestrebt, die Konzentrationen schädlicher Verunreinigungen so niedrig wie möglich zu halten. Häufig wird beobachtet, daß bereits hochrein hergestelltes Halbleitermaterial im Verlauf der weiteren Verarbeitung zu den Zielprodukten erneut kontaminiert wird. So werden immer wieder aufwendige Reinigungsschritte notwendig, um die ursprüngliche Reinheit zurückzuerhalten. Fremdmetallatome, die in das Kristallgitter des Halbleitermaterials eingebaut werden, stören die Ladungsverteilung und können die Funktion des späteren Bauteils vermindern oder zu dessen Ausfall führen. Infolgedessen sind insbesondere Kontaminationen des Halbleitermaterials durch metallische Verunreinigungen zu vermeiden. Dies gilt insbesondere für Silicium, das in der Elektronikindustrie mit deutlichem Abstand am häufigsten als Halbleitermaterial eingesetzt wird. Hochreines Silicium erhält man beispielsweise durch thermische Zersetzung leicht flüchtiger und deshalb einfach über Destillationsverfahren zu reinigender Siliciumverbindungen, wie beispielsweise Trichlorsilan. Es fällt dabei polykristallin in Form von Stäben mit typischen Durchmessern von 70 bis 300 mm und Längen von 500 bis 2500 mm an. Ein großer Teil der Stäbe wird zur Produktion von tiegelgezogenen Einkristallen, von Bändern und Folien oder zur Herstellung von polykristallinem Solarzellengrundmaterial verwendet. Da diese Produkte aus hochreinem, schmelzflüssigem Silicium hergestellt werden, ist es notwendig, festes Silicium in Tiegeln aufzuschmelzen. Um diesen Vorgang möglichst effektiv zu gestalten, müssen großvolumige, massive Siliciumstücke, wie beispielsweise die erwähnten polykristallinen Stäbe, vor dem Aufschmelzen zerkleinert werden. Dies ist üblicherweise immer mit einer oberflächlichen Verunreinigung des Halbleitermaterials verbunden, weil die Zerkleinerung mit metallischen Brechwerkzeugen, wie Backen- oder Walzenbrechern, Hämmern oder Meißeln, erfolgt.

Bei der Zerkleinerung ist sorgfältig darauf zu achten, daß die Oberflächen der Bruchstücke nicht mit Fremdstoffen verunreinigt werden. Insbesondere ist die Kontamination durch Metallatome als kritisch anzusehen, da diese die elektrischen Eigenschaften des Halbleitermaterials in schädlicher Weise verändern können. Wird das zu zerkleinernde Halbleitermaterial, wie bisher überwiegend üblich, mit mechanischen Werkzeugen, wie beispielsweise stählernen Brechern, zerkleinert, so müssen die Bruchstücke vor dem Aufschmelzen einer Oberflächenreinigung unterzogen werden.

Um mechanisch bearbeitetes, polykristallines Silicium oder polykristalline Siliciumkörner, die aus mechanisch bearbeiteten Artikeln als Kernsilicium zur Herstellung von monokristallinem Silicium erzeugt sind, als Ausgangsmaterial einsetzen zu können, ist es notwendig, die Konzentration an Eisen- und/oder Chrom-Atomen herabzusetzen, die auf der Oberfläche des mechanisch bearbeiteten polykristallinen Siliciums vorhanden sind.

Deshalb wird bei Verwendung der mechanisch bearbeiteten Partikel aus polykristallinem Silicium als Ausgangsmaterial für monokristallines Silicium die Oberfläche des mechanisch bearbeiteten polykristallinen Siliciums mit einer Mischung aus Salpetersäure und Fluorwasserstoffsäure geätzt. Dieses Verfahren wird weithin angewandt, dadurch kann allerdings nicht die Konzentration an Eisen- und/oder Chromatomen auf der Oberfläche des Polysiliciums genügend herabgesetzt werden.

Reinigungsverfahren sind weitere bekannt, wie zum Beispiel aus DE-A-195 29 518, in der polykristallines Silicium zuerst mit einer Mischung aus Königswasser (Mischung aus Salzsäure und Salpetersäure) gereinigt und des weiteren einer Reinigung mit Fluorwasserstoffsäure unterzogen wird. Durch diese Verfahren wird jedoch lediglich ein Eisenmittelwert von $73,32 \times 10^{-11}$ g/cm$^2$ erreicht.

In JP-A-051-54466 wird ein Reingungsverfahren beschrieben, bei dem Fluorwasserstoffsäure und Salpetersäure verwendet werden. Es wurde ein Eisenmittelwert von $23,31 \times 10^{-11}$ g/cm$^2$ erreicht.

Aufgabe der vorliegende Erfindung ist es daher, den Stand der Technik zu verbessern und ein Verfahren zur Herstellung von silicium, insbesondere polykristallines Silicium, das einen sehr geringen Eisen-/Chromgehalt aufweist, bereitzustellen.

Diese Aufgaben werden durch die vorliegende Erfindung gelöst.

Die Erfindung erlaubt ein Halbleitermaterial herzustellen, das eine geringe Metallkonzentration an der Oberfläche aufweist, wobei es einen Eisen- und/oder Chromgehalt auf der Oberfläche von unter $6,66 \times 10^{-11}$ g/cm$^2$ aufweist.

Dieses Halbleitermaterial weist einen Partikeldurchmesser von 0,1 bis 350 mm, bevorzugt 20 bis 150 mm auf.

Bei dem Halbleitermaterial handelt es sich um Halbleitermaterial, wie Silicium, Indiumphosphid, Germanium oder Galliumarsenid. Bevorzugt ist Silicium, insbesondere polykristallines Silicium.

Ein polykristalliner Siliciumstab wird mittels metallischer Brechwerkzeuge zerkleinert. Diese sind aus Stahl, das durch Eisencarbid und/oder Chromcarbid gehärtet ist.

Beim Zerkleinern des polykristallinen Siliciums mit diesen Metallen werden die Metallpartikel in die Oxidschicht und die obersten Lagen des Siliciumsgitters eingedrückt. Aus diesem Grund können Reinigungsmischungen ohne Siliciumabtrag, zum Beispiel HCl/H$_2$O$_2$ den Metallabrieb nicht vollständig entfernen. Eine vollständige Reinigung ist somit notwendig.

Der Gegenstand der Erfindung ist im Anspruch 1 definiert.

In einer Vorreinigung wird das Halbleitermaterial, insbesondere der polykristalline Siliciumbruch, vorzugsweise zuerst mit vollentsalztem Wasser mit 15 - 18 MOhm abgespült, mit einer oxidierenden Reinigungslösung die die Verbindungen Fluorwasserstoffsäure, Chlorwasserstoffsäure und wasserstoffperoxid enthält gewaschen.

Alle diese oxidierenden Stoffe lassen sich auch, soweit technisch möglich, in beliebigen Gemischen einsetzen. Des weiteren können auch noch Tenside, wie vorzugsweise Ammoniumlaurylsulfat oder Natriumalkylsulfat, enthalten sein.

Bevorzugt ist eine oxidierende Reinigungslösung, die Salzsäure mit 4 bis 20 Gew.%, Fluorwasserstoffsäure mit 1 bis 10 Gew.% und Wasserstoffperoxid mit 1 bis 5 Gew.% als Gemisch enthält. Die Gew.% beziehen sich auf die gesamte Reinigungslösung. Nach dieser Vorreinigung erfolgt vorzugsweise ein Spülschritt mit vollentsalztem Wasser mit 15 - 18 MOhm.

Daran schließt sich die Hauptreinigung an, bei der eine Mischung aus Salpetersäure und Fluorwasserstoffsäure eingesetzt wird. Diese Mischung enthält vorzugsweise 60 bis 70 Gew.% Salpetersäure, 1 bis 5 Gew.% Fluorwasserstoffsäure und Wasser. Die Gew.% beziehen sich auf die gesamte Reinigungslösung.

Diese Hauptreinigung kann auch vorzugsweise aufgeteilt werden, indem zuerst mit einer Reinigungslösung gewaschen wird, die Fluorwasserstoffsäure und Salpetersäure enthält, wobei die Salpetersäure einen Gehalt von kleiner 70 Gew.% aufweist, wobei diese Mischung vorzugsweise 60 bis 70 Gew.% Salpetersäure, 1 bis 5 Gew.% Fluorwasserstoffsäure und Wasser enthält und in einem weiteren Schritt mit einer Reinigungslösung gewaschen wird, die Fluorwasserstoffsäure und Salpetersäure enthält, wobei die Salpetersäure einen Gehalt von größer 70 Gew.% aufweist, gewaschen wird, wobei diese Mischung vorzugsweise 70 bis 95 Gew.% Salpetersäure, 1 bis 5 Gew.% Fluorwasserstoffsäure und Wasser enthält. Die Gew.% beziehen sich auf die gesamte Reinigungslösung. Die Hauptreinigung in zwei Schritten ermöglicht einen Ätzabtrag unter 5 µm.

Des weiteren können in den Gemischen aus Salpetersäure und Fluorwasserstoffsäure die oben genannten Mineralsäuren, flüssige, lineare oder verzweigte organische Säuren mit 1 bis 8 Kohlenstoffatomen, Wasserstoffperoxid und Tenside enthalten sein. Alle Stoffe können in beliebigen Konzentrationen und Mischungsverhältnissen, soweit dies technisch möglich ist, enthalten sein.

Nach dieser Vorreinigung erfolgt vorzugsweise ein Spülschritt mit vollentsalztem Wasser mit 15 - 18 MOhm.

Daran schließt sich eine Hydrophilierung mit einer oxidierenden Reinigungsflüssigkeit an. Bei dieser Reinigungslösung handelt es sich vorzugsweise um Mineralsäuren, wie oben definiert, und flüssige, lineare oder verzweigte organische Säuren mit 1 bis 8 Kohlenstoffatomen, wie oben definiert; alle diese Stoffe lassen sich auch, soweit technisch möglich, in beliebigen Gemischen einsetzen, wobei auch noch Wasserstoffperoxid enthalten sein kann. Des weiteren können auch noch Tenside, wie oben definiert, enthalten sein.

Bevorzugt ist eine Reinigungslösung, die vorzugsweise Salzsäure mit 4 bis 20 Gew.% und 1 bis 3 Gew. % Wasserstoffperoxid, Salpetersäure mit 8 bis 70 Gew.% und Wasser enthält. Die Gew.% beziehen sich auf die gesamte Reinigungslösung. Nach dieser Hydrophilierung erfolgt vorzugsweise ein Spülschritt mit vollentsalztem Wasser mit 15 - 18 MOhm.

Vorzugsweise erfolgen alle Reinigungsschritte derart, daß das zu reinigende Halbleitermaterial in einem Behälter, der Öffnungen aufweist, in eine Reinigungsflüssigkeit eingetaucht wird und Reinigungsflüssigkeit durch die Öffnungen einströmt und das polykristalline Silicium benetzt, sodann wird der Behälter soweit aus der Flüssigkeit gehoben, daß die Reinigungsflüssigkeit durch die Öffnungen des Behälters vollständig herausströmen kann. Zu diesen Reinigungsflüssigkeiten gehört auch die Wäsche mit vollentsalztem Wasser mit 15 - 18 MOhm.

Bei dem erfindungsgemäßen Verfahren wird das Halbleitermaterial in einem Behälter zumindest zweimal mittels einer Hub-, Senkbewegung in die Reinigungsflüssigkeit eingetaucht. Vorzugsweise werden diese Hub- und Senkbewegungen so ausgeführt, daß die Behälter, während sie aus der Reinigungslösung gehoben sind, sich vollständig entleeren können, wobei die Reinigungslösung vollständig herausströmt.

Vorzugsweise wird diese Hub- und Senkbewegung 10 mal in der Minute für bis zu 4 Minuten durchgeführt.

Das Reinigungsverfahren wird vorzugsweise bei Normaldruck und Raumtemperatur (25 °C) durchgeführt, wobei das Hauptreinigungsverfahren bevorzugt bei 5 °C bis 12 °C und besonders bevorzugt bei 8 °C bis 10 °C ausgeführt wird. Aufgrund der niedrige Temperatur läßt sich die Verweildauer (zum Beispiel 3 bis 5 Sekunden auf 7 bis 10 Sekunden) verlängern, was sich auf eine Verminderung der Fleckenbildung auswirkt.

Reinigungsvorrichtungen für das Reinigen von Halbleitermaterial, wobei das Halbleitermaterial, insbesondere der polykristalliner Siliciumbruch, in einer Walze gedreht oder durch eine Hub- und Senkbewegungen innerhalb der Säure auf und ab bewegt wird, sind bekannt. Beim Walzenverfahren entsteht bei der Umlagerung der scharfkantigen Polysiliciumbruchstücken beträchtlicher Kunststoffabrieb, der die Bäder und damit die Polysiliciumbruch-Oberfläche verunreinigt. Das Hub- und Senkbewegungensverfahren zeichnet sich dadurch aus, daß eine zu geringe Strömung durch das Polysilicium-Schüttgut die Reinigungswirkung reduziert (siehe auch Vergleichsversuch Tabelle 10).

Das erfindungsgemäße Verfahren kann in einer Reingungsvorrichtung ausgeführtwerden, die einen Behälter mit Öffnungen aufweist, wobei die Reingungsvorrichtung den Behälter mittels Hub- und Senkbewegung so bewegt, daß der Behälter vollständig aus der Reinigungsflüssigkeit entfernt wird.

Die Reinigungsvorrichtung ist derart aufgebaut, daß vorzugsweise ein Motor mit Hub- und Senkbewegungen einen vorzugsweise rechteckigen Behälter, in dem sich das Halbleitermaterial befindet, der zumindest im Boden Öffnungen aufweist, mit Hub- und Senkbewegungen so aus der Reinigungsflüssigkeit hebt, das der Behälter vollständig aus der Reinigungsflüssigkeit entfernt wird und sich während jeder dieser Hub- und Senkbewegungen auch vollständig entleert.

Vorzugsweise weist der Behälter am Boden des Behälters pyramidenförmige Aussparungen auf, die bevorzugt mit der Pyramidenspitze vom Boden des Behälters nach oben weisen, so daß der Boden des Behälters mit pyramidenförmigen Aussparungen bedeckt ist, deren Spitzen vom Boden vorzugsweise senkrecht oder auch leicht geneigt nach oben weisen.

Diese pyramidenförmigen Aussparungen weisen Öffnungen auf, die sich vorzugsweise in den Dreiecksseiten der pyramidenförmigen Aussparungen befinden. Durch diese Öffnungen kann beim erfindungsgemäßen Verfahren die Reinigungsflüssigkeit abfließen. Diese Öffnungen haben eine Größe von vorzugsweise 2 mm bis 8 mm, besonders bevorzugt von 2 mm bis 4 mm.

Ein Vorteil der Erfindung ist, daß ein Halbleitermaterial mit einem Eisen- und/oder Chromgehalt auf der Oberfläche von unter $6,66 \times 10^{-11}$ g/cm$^2$, vorzugsweise einem Eisen- und/oder Chromgehalt auf der Oberfläche von unter $2 \times 10^{-11}$ g/cm$^2$, besonders bevorzugt von $1 \times 10^{-11}$ g/cm$^2$ aufweist, erhalten werden kann. Des weiteren weist das so gereinigte Halbleitermaterial keine Flecken mehr auf, wie sie sonst mit üblichen Reinigungsvorrichtungen auftreten.

Vergleich verschiedener Reinigungsverfahren nach dem Stand der Technik

Die Eisenwerte werden in $10^{-11}$ g/cm$^2$ abgegeben.

Tabelle 1

| Verfahren | Literaturstelle | Eisenmittelwert | Standardabweichung | Anzahl der Werte |
|---|---|---|---|---|
| Ätze HF/HNO$_3$ 20 Min 50 μm | 5/3 | 23,31 | 19.98 | 15 |
| HCl/H$_2$O$_2$ | 1,2 | 59,94 | 99,9 | 12 |
| HF 5 Gew% HCl 8 Gew% H$_2$O$_2$ 2 Gew% | 1,2 | 13,32 | 13,32 | 1.000 |
| RCA-Reinigung | 1,2 | 9,96 | 39,96 | 14 |
| HF/H$_2$O$_2$ | 4 | 1,98 | 13,32 | 15 |
| HCl/HNO$_3$ 15 Min HF 5 Gew% 5 Min 2 mal | 3 | 73,32 | 53,32 | 10 |
| | | | | |

Literaturstellen:

1. ) RCA-Reinigung
RCA Rewiew June 1970, W. Kern

2.) Semiconductor International April 1984
Purifying Si and SiO$_2$ Surfaces with Hydrogen Peroxid

3.) Offenlegungschrift
DE-A-195 29518
Tokuyama Corp.
Polykristallines Silicium und Verfahren zur Herstellung

4.) Czochralski method for cleaning polysilicon by using mixt. of hydrogen fluoride, hydrogenperoxide and water
JP-A-05004811
Shinetsu Handotai Co. Ltd.

5.) Hi-silicon Co. Ltd. Kojundo silicon KK
JP-A-05154466
Cleaning Polysilicon by washing with mixt. of nitric and HF acid

Durchführung der Metallanalysen am gereinigten Polybruch

In einem Teflontrichter werden 100 g schweres Polysilicium mit 40 ml HF/HNO$_3$ 1 : 4 abgespritzt. Die Ätzsäure wird in einem Teflonbecher aufgefangen. Anschließend wird die Säure abgedampft und der Rückstand in 5 ml Wasser aufgenommen. Der Metallgehalt der wäßrigen Lösung wird am ICP-AES (Induktiv-gekoppeltes Ionenplasma-Atomemissionsspektroskop der Firma Spectro)-Gerät gemessen. Aus den gemessenen Werten wird der Metallgehalt der Polyoberfläche berechnet. Die Angaben erfolgen in g/cm$^2$.

Vergleich verschiedener Reinigungsverfahren zum Entfernen von Edelstahlabrieb von der Siliciumoberfläche

Die Eisenwerte werden in 10$^{-11}$ g/cm$^2$ angegeben

Tabelle 2

| Verfahren | Eisenmittelwert | Standardabweichung | Chrommittelwert | Standardabweichung | Anzahl der Werte |
|---|---|---|---|---|---|
| Ätze HF/HNO$_3$ 20 Min 50 µm | 23,31 | 19,98 | 13,32 | 1,33 | 15 |
| HCl/H$_2$O$_2$ | 59,94 | 99,9 | 19,98 | 2,22 | 12 |
| Beize HF 5 Gew% HCl 8 Gew% H$_2$O$_2$ 3 Gew% | 39,96 | 26,64 | 19,98 | 1,66 | 12 |
| Beize /Ätze 12 µm | < 6,66 | | < 6,66 | | 13 |
| Ätze HF/HNO$_3$ 60 Min 400 µm | 19,98 | 16,65 | 13,32 | 1,33 | 10 |

In den folgenden Beispielen werden die erfindungsgemäßen Bedingungen des kombinierten Verfahrens näher erläutert:

Beispiel 1

Ein Polysiliciumstab wird beim Kontakt mit Metallwerkzeugen im Mittel auf der Polysiliciumoberfläche mit $1332 \times 10^{-11}$ g/cm$^2$ Eisen verunreinigt. Die anschließende Reinigung erfolgt wie in Tabelle 3 beschrieben. Der Tabelle können die erforderlichen Säurekonzentrationen, der Ätzabtrag und die Reinigungszeiten für die Herstellung eines Polybruches mit einem Eisengehalt auf der Polysiliciumoberfläche von $< 6,66 \times 10^{-11}$ g/cm$^2$ entnommen werden.

Bedingungen bei der Durchführung des Beiz-/Ätzprozesses

Tabelle 3

| Teilschritt | Reaktions zeit | Tempe ratur | Ätzabtrag |
|---|---|---|---|
| Abspülen mit Wasser | 5 Minuten | $25 \pm 5$ Grad | - |
| Vorreinigung: Beize HF 5 Gew% HCl 8 Gew% H$_2$O$_2$ 3 Gew% | 20 Minuten | 22 Grad | 0.02 μm |
| Spülen | 5 Minuten | 22 Grad | - |
| Hauptreinigung: Ätzen HF/HNO$_3$ 3 Gew% HF 65 Gew% HNO$_3$ | 5 Minuten | 8 Grad | 12 μm |
| Spülen | 5 Minuten | 22 Grad | - |
| Hydrophilierung HCl 8 Gew% H$_2$O$_2$ 2 Gew% | 5 Minuten | 22 Grad | - |
| Spülen | 5 Minuten | 22 Grad | - |
| Trocknen mit Reinstluft Klasse 100 | 20 Minuten | 80 Grad | - |

Beispiel 2

100 g Polysilicium wird mit einer V4A-Edelstahlschraube 10 Sekunden lang abgerieben. Das ungereinigte Polysilicium enthält auf der Oberfläche im Mittel $666000 \times 10^{-11}$ g/cm$^2$ Eisen und $133200 \times 10^{-11}$ g/cm$^2$ Chrom. Die anschließende Reinigung erfolgt wie in Tabelle 3 beschrieben.

Beispiel 3

Ein Polysiliciumstab wird in einem Brecher mit Metallbacken zerkleinert. Das ungereinigte Material enthält im Mittel auf der Polysiliciumoberfläche $5328 \times 10^{-11}$ g/cm$^2$ Eisen. Die anschließende Reinigung erfolgt wie in Tabelle 4 beschrieben. Der Tabelle können die erforderlichen Säurekonzentrationen, der Ätzabtrag und die Reinigungszeiten für die Herstellung eines Polysiliciumsbruches mit einem Eisengehalt auf der Oberfläche von $< 6,66 \times 10^{-11}$ g/cm$^2$ entnommen werden.

Bedingungen bei der Durchführung des Beiz-/Ätzprozeßes für Material aus Beispiel 3

Tabelle 4

| Teilschritt | Reaktionszeit | Temperatur | Ätzabtrag |
|---|---|---|---|
| Abspülen mit Wasser | 6 Minuten | $25 \pm 5$ Grad | - |

Tabelle 4   (fortgesetzt)

| Teilschritt | Reaktionszeit | Temperatur | Ätzabtrag |
|---|---|---|---|
| Voreinigung:<br>Beize HF 5 Gew%<br>HCl 8 Gew%<br>$H_2O_2$<br>3 Gew% | 48 Minuten | 22 Grad | 0,05 µm |
| Spülen | 6 Minuten | 22 Grad | - |
| Hauptreinigung:<br>Ätzen<br>$HF/HNO_3$ 3<br>Gew%<br>HF 65 Gew%<br>$HNO_3$ | 12 Minuten | 8 Grad | 40 µm |
| Spülen | 6 Minuten | 22 Grad | - |
| Hydrophilierung<br>HCl 8 Gew%<br>$H_2O_2$<br>2 Gew% | 12 Minuten 22 | Grad | - |
| Spülen | 5 Minuten | 22 Grad | - |
| Trocknen mit Reinstluft Klasse 100 | 20 Minuten | 80 Grad | - |

Durch ein kombiniertes Verfahren mit einem Hauptreinigungsschritt aus zwei Stufen (Hauptreinigung mit einer Reinigungslösung, die Fluorwasserstoffsäure und Salpetersäure enthält, wobei die Salpetersäure einen Gehalt von kleiner 70 Gew.% aufweist und in einem weiteren Schritt mit einer Reinigungslösung, die Fluorwasserstoffsäure und Salpetersäure enthält, wobei die Salpetersäure einen Gehalt von größer 70 Gew.% aufweist) kann stark mit Eisen und Chrom verunreinigtes Polysilicium mit einem Partikeldurchmesser von 0.1 bis 350 mm auf einen Eisen- und Chromgehalt auf der Oberfläche von $< 6,66 \times 10^{-11}$ g/cm$^2$ gereinigt werden. Bei diesem vierstufigen Prozeß werden im Vergleich zum dreistufigen kombinierten 12 µm Verfahren weniger als 5 µm von der Siliciumoberfläche abgetragen.

Vergleich der beiden kombinierten Reinigungsverfahren

Die Eisenwerte werden in $10^{-11}$ g/cm$^2$ angegeben.

Tabelle 5

| Verfahren | Eisenmittelwerte | Standardabweichung | Anzahl der Werte |
|---|---|---|---|
| Dreistufiges Verfahren mit Ätzabtrag von 12µm | 3,33 | 3,33 | 300 |
| Vierstufiges Verfahren mit einem Ätzabtrag von < 5µm | 3,33 | 3,33 | 20 |

Im Unterschied zum dreistufigen Verfahren wird im ersten Ätzschritt (Abtrag ca. 2 µm) in der $HF/HNO_3$ mit 0,5 Gew% HF und weniger als 70 Gew% $HNO_3$ ein fleckiger grauer Bruch erhalten. Der Eisengehalt auf der Polysiliciumoberfläche von $3,33 \times 10^{-11}$ g/cm$^2$ ist nach der ersten Ätze bereits erreicht. Der zweite Ätzschritt (ca. 2 µm) erfolgt bei 0.5 Gew% HF und mehr als 70 Gew% $HNO_3$. Durch diese Säurebehandlung werden die grauen Flecken entfernt.

Durch die Reduzierung des Ätzabtrages gegenüber dem dreistufigen Verfahren von 12 auf unter 5 µm wird der Säureverbrauch und die $NO_x$-Gasentwicklung (s.Tabelle 6) um mehr als 50 % reduziert.

Vergleich der $NO_x$-Gasentwicklung und des Säureverbrauchs zwischen dem dreistufigen und vierstufigen kombinierten Reinigungsverfahren.

Konzentration der verwendeten Säuren

HNO$_3$ : 70 Gew%
HF: 50 Gew%

Tabelle 6

| Verfahren | HF/HNO$_3$ Verbrauch für 480 kg Polysilicium bruch | NO$_x$-Gehalt für 3000 m$^3$-Abluft |
|---|---|---|
| Dreistufiges Verfahren 12 µm | 220 Liter HNO$_3$ 27 Liter HF | 1000 mg/m$^3$ |
| Vierstufiges Verfahren < 5 µm | 100 Liter HNO$_3$ 10 Liter HF | 350 mg/m$^3$ |

Beim Auflösen des Polysiliciums wird HF verbraucht und gleichzeitig entsteht Wasser (s. Reaktionsgleichung 1). Zur Aufrechterhaltung der Badkonzentrationen bezüglich des HNO$_3$ und HF-Gehaltes muß deshalb ständig Flußsäure und Salpetersäure nachdosiert werden. Vorteile im Säureverbrauch entstehen durch die Verwendung von 100 Gew% HNO$_3$ und 70 Gew% HF oder HF-Gas (s. Tabelle 7).
Reakationsgleichung Nr.1

$$3 \text{ Si} + 4 \text{ HNO}_3 + 18 \text{ HF} \Leftrightarrow 2 \text{ H}_2\text{SiF}_6 + 4 \text{ NO} + 8 \text{ H}_2\text{O}$$

Vergleich der Säureverbräuche bei verschiedenen Dosiermethoden

Tabelle 7

| Verfahren | HF/HNO$_3$-Verbrauch bei Verwendung von 70 Gew% HNO$_3$ und 50 Gew% HF für 480 kg Polysiliciumbruch | HF/HNO$_3$-Verbrauch bei Verwendung von 100 Gew% HNO$_3$ und 70 Gew% HF für 480 kg Polysiliciumbruch |
|---|---|---|
| Dreistufiges Verfahren 12 µm Abtrag | 220 Liter HNO$_3$ 27 Liter HF | 50 Liter HNO$_3$ 15 Liter HF |
| Vierstufiges Verfahren < 5 µm Abtrag | 100 Liter HNO$_3$ 10 Liter HF | 20 Liter HNO$_3$ 6 Liter HF |

Durchführung der Metallanalysen am gereinigten Polysiliciumbruch

In einem Teflontrichter wird 100 g schweres Polysilicium mit 40 ml HF/HNO$_3$ 1 : 4 abgespritzt. Die Ätzsäure wird in einem Teflonbecher aufgefangen. Anschließend wird die Säure abgedampft und der Rückstand in 5 ml Wasser aufgenommen. Der Metallgehalt der wässrigen Lösung wird am ICP-AES(Induktiv-gekoppeltes Ionenplasma-Atomemissionsspektroskop der Firma Spectro)-Gerät gemessen. Aus den gemessenen Werten wird der Metallgehalt der Polyoberfläche berechnet. Die Angaben erfolgen in g/cm$^2$.

In den folgenden Beispielen werden die experimentellen Bedingungen des vierstufigen kombinierten Verfahrens näher erläutert:

Beispiel 4

Ein Polysiliciumstab wird beim Kontakt mit Metallwerkzeugen im Mittel auf der Polysiliciumoberfläche mit 1332x10$^{-11}$ g/cm$^2$ Eisen verunreinigt. Die anschließende Reinigung erfolgt wie in Tabelle 8 beschrieben. Der Tabelle können die erforderlichen Säurekonzentrationen, der Ätzabtrag und die Reinigungszeiten für die Herstellung eines Polybruches mit einem Eisengehalt auf der Polysiliciumoberfläche von < 6,66x10$^{-11}$ g/cm$^2$ entnommen werden.

Bedingungen bei der Durchführung des Beiz-/Ätzprozeßes

Tabelle 8

| Teilschritt | Reaktionszeit | Temperatur | Ätzabtrag |
|---|---|---|---|
| Abspülen mit Wasser | 5 Minuten | 25 ± 5 Grad | - |
| Vorreinigung:<br>Beize<br>HF 5 Gew%<br>HCl 8 Gew%<br>$H_2O_2$<br>3 Gew% | 20 Minuten | 22 Grad | 0,02 μm |
| Spülen | 5 Minuten | 22 Grad | - |
| Hauptreinigung:<br>Ätze Nr. 1<br>$HF/HNO_3$<br>0,6 Gew%<br>HF<br>63 Gew%<br>$HNO_3$ | 2,5 Minuten | 8 Grad | 2 μm |
| Hauptreinigung:<br>Ätze Nr. 2<br>$HF/HNO_3$<br>0,6 Gew%<br>HF<br>> 70 Gew%<br>$HNO_3$ | 2,5 Minuten | 8 Grad | 2 μm |
| Spülen | 5 Minuten | 22 Grad | - |
| Hydrophilierung<br>HCl 8 Gew%<br>$H_2O_2$<br>3 Gew% | 5 Minuten | 22 Grad | - |
| Spülen | 5 Minuten | 22 Grad | - |
| Trocknen mit Reinstluft Klasse 100 | 20 Minuten | 80 Grad | - |

Beispiel 5

100 g Polysilicium wird mit einer V4A-Edelstahlschraube 10 Sekunden lang abgerieben. Das ungereinigte Polysilicium enthält auf der Oberfläche im Mittel $666000 \times 10^{-11}$ g/cm² Eisen und $133200 \times 10^{-11}$ g/cm² Chrom. Die anschließende Reinigung erfolgt wie in Tabelle 8 beschrieben.

Beispiel 6

Ein Polysiliciumstab wird in einem Backenbrecher mit Metallbacken zerkleinert. Das ungereinigte Material enthält im Mittel auf der Polysiliciumoberfläche mit $5328 \times 10^{-11}$ g/cm² Eisen. Die anschließende Reinigung erfolgt wie in Tabelle 9 beschrieben. Der Tabelle können die erforderlichen Säurekonzentrationen, der Ätzabtrag und die Reinigungszeiten für die Herstellung eines Polybruches mit einem Eisengehalt auf der Polysiliciumoberfläche von < $6,66 \times 10^{-11}$ g/cm² entnommen werden.

Bedingungen bei der Durchführung des Beiz-/Ätzprozeßes für Material aus Beispiel 6

Tabelle 9

| Teilschritt | Reaktionszeit | Temperatur | Ätzabtrag |
|---|---|---|---|
| Abspülen mit Wasser | 5 Minuten | 25 ± 5 Grad | - |
| Vorreinigung:<br>Beize<br>HF 5 Gew%<br>HCl 8 Gew%<br>$H_2O_2$<br>3 Gew% | 48 Minuten 22 | Grad | 0,02 µm |
| Spülen | 6 Minuten | 22 Grad | - |
| Hauptreinigung:<br>Ätze Nr. 1<br>$HF/HNO_3$<br>0,6 Gew%<br>HF<br>63 Gew%<br>$HNO_3$ | 6 Minuten 8 | Grad | 5 µm |
| Hauptreinigung:<br>Ätze Nr. 2<br>$HF/HNO_3$<br>0,6 Gew%<br>HF<br>> 70 Gew%<br>$HNO_3$ | 6 Minuten | 8 Grad | 5 µm |
| Spülen | 6 Minuten | 22 Grad | - |
| Hydrophilierung<br>HCl 8 Gew%<br>$H_2O_2$<br>3 Gew% | 12 Minuten 22 | Grad | - |
| Spülen | 6 Minuten | 22 Grad | - |
| Trocknen mit Reinstluft Klasse 100 | 20 Minuten | 80 Grad | - |

Einfluß der Art der Hub-/Senkbewegung auf den Beiz-/Ätzprozeß

Die Eisenwerte werden in $10^{-11}$ g/cm$^2$ angegeben

Tabelle 10

| Art der Hub-/Senkbewegung | Eisenmittelwerte | Standardabweichung | Anzahl der Werte |
|---|---|---|---|
| Nur in der Säure auf und ab bewegen | 13.32 | 13.32 | 25 |
| Bewegung, bei der die Prozeßschale ständig befüllt und entleert wird | 3.33 | 3.33 | 200 |

**Patentansprüche**

**1.**   Verfahren zur Herstellung von Silicium, das eine niedrige Metallkonzentration aufweist, **dadurch gekennzeichnet, daß** das Silicium in einer Vorreinigung in zumindest einer Stufe mit einer oxidierenden Reinigungslösung gewaschen wird, die die Verbindungen Fluorwasserstoffsäure, Chlorwasserstoffsäure und Wasserstoffperoxid enthält und in einer Hauptreinigung in einer weiteren Stufe mit einer Reinigungslösung gewaschen wird, die Salpetersäure und Fluorwasserstoffsäure enthält, und zur Hydrophilierung in einer weiteren Stufe mit einer oxidierenden Reinigungslösung gewaschen wird.

**2.** Verfahren nach Anspruch 1, **dadurch gekennzeichnet, daß** das Silicium bei der Hauptreinigung mit einer Reinigungslösung gewaschen wird, die Fluorwasserstoffsäure und Salpetersäure enthält, wobei die Salpetersäure einen Gehalt von kleiner 70 Gew.-% aufweist, und in einem weiteren Schritt mit einer Reinigungslösung gewaschen wird, die Fluorwasserstoffsäure und Salpetersäure enthält, wobei die Salpetersäure einen Gehalt von größer 70 Gew.-% aufweist.

**3.** Verfahren nach einem der Ansprüche 1 bis 2, **dadurch gekennzeichnet, daß** das Silicium bei der Hauptreinigung zusätzlich mit einem oder mehreren flüssigen Reinigungsmitteln aus der Gruppe, die aus flüssigen organischen Säuren, Mineralsäuren und Wasserstoffperoxid besteht, gewaschen wird.

**4.** Verfahren nach einem der Ansprüche 1 bis 3, **dadurch gekennzeichnet, daß** das Silicium in einem Behälter in die Reinigungsflüssigkeit eingetaucht wird, wobei der Behälter Öffnungen aufweist, und die Reinigungsflüssigkeit durch die Öffnungen einströmt und das Silicium benetzt, und der Behälter so weit aus der Flüssigkeit gehoben wird, daß die Reinigungsflüssigkeit durch die Öffnungen des Behälters vollständig herausströmen kann.

**5.** Verfahren nach einem der Ansprüche 1 bis 4, **dadurch gekennzeichnet, daß** das Silicium in einem Behälter zumindest zweimal mittels einer Hub-Senk-Bewegung in die Reinigungsflüssigkeit eingetaucht wird.

**Claims**

**1.** Method for producing silicon which has a low metal concentration, **characterized in that** the silicon is washed in a preliminary cleaning in at least one stage with an oxidizing cleaning solution, which contains the compounds hydrofluoric acid, hydrochloric acid and hydrogen peroxide, and is washed in a main cleaning in a further stage with a cleaning solution which contains nitric acid and hydrofluoric acid and, for hydrophilization, is washed in a further stage with an oxidizing cleaning solution.

**2.** Method according to Claim 1, **characterized in that** the silicon is washed during the main cleaning with a cleaning solution containing hydrofluoric acid and nitric acid, the content of nitric acid being less than 70% w/w, and is washed in a further step with a cleaning solution which contains hydrofluoric acid and nitric acid, the content of nitric acid being greater than 70% w/w.

**3.** Method according to one of Claims 1 to 2, **characterized in that** the silicon is additionally washed during the main cleaning with one or more liquid cleaning agents from the group comprising liquid organic acids, mineral acids and hydrogen peroxide.

**4.** Method according to one of Claims 1 to 3, **characterized in that** the silicon is immersed in a container having openings in a cleaning liquid and the cleaning liquid flows in through the openings and wets the silicon, then the container is raised far enough out of the liquid for the cleaning liquid to be able to flow completely out through the openings in the container.

**5.** Method according to one of Claims 1 to 4, **characterized in that** the silicon in a container is immersed at least twice in the cleaning liquid by means of a lifting and lowering movement.

**Revendications**

**1.** Procédé pour la préparation de silicium qui présente une faible concentration de métaux, **caractérisé en ce que**, dans une purification préliminaire, on lave le silicium en au moins une étape, avec une solution oxydante de nettoyage qui contient les composés acide fluorhydrique, acide chlorhydrique et peroxyde d'hydrogène, et, dans une purification principale, on le lave dans une autre étape avec une solution de nettoyage qui contient de l'acide nitrique et de l'acide fluorhydrique, et, pour l'hydrophilisation, on le lave dans une autre étape avec une solution oxydante de nettoyage.

**2.** Procédé selon la revendication 1, **caractérisé en ce que**, dans la purification principale, on lave le silicium avec une solution de nettoyage qui contient de l'acide fluorhydrique et de l'acide nitrique, l'acide nitrique étant à une concentration de moins de 70 % en poids, et, dans une autre étape, on le lave avec une solution de nettoyage qui contient de l'acide fluorhydrique et de l'acide nitrique, l'acide nitrique étant à une concentration de plus de 70 % en poids.

3. Procédé selon la revendication 1 ou 2, **caractérisé en ce que**, dans la purification principale, le silicium est en outre lavé avec un ou plusieurs agents liquides de nettoyage choisis dans le groupe constitué par des acides organiques liquides, des acides minéraux et le peroxyde d'hydrogène.

4. Procédé selon l'une quelconque des revendications 1 à 3, **caractérisé en ce que**, dans un récipient, le silicium est immergé dans le liquide de nettoyage, le récipient présentant des orifices et le liquide de nettoyage pénétrant par les orifices et mouillant le silicium, et on élève le récipient le récipient hors du liquide jusqu'à ce que le liquide de nettoyage puisse s'écouler totalement du récipient par les orifices du récipient.

5. Procédé selon l'une quelconque des revendications 1 à 4, **caractérisé en ce que** le silicium est immergé dans un récipient au moins deux fois, à l'aide d'un mouvement de montée-descente, dans le liquide de nettoyage.